# EUROPEAN PATENT APPLICATION

(11) **EP 4 827 265 A1**
(43) Date of publication of application: **21.10.2026**
(21) Application number: 24910257.5
(22) Date of filing: 28.10.2024
(51) Int. Cl.: H10B 53/30, G11C 11/22

(54) **FERROELECTRIC CAPACITOR AND PREPARATION METHOD THEREFOR, STORAGE ARRAY, MEMORY, AND ELECTRONIC DEVICE**

(30) Priority: 29.12.2023 CN 202311872523
(71) Applicant: Huawei Technologies Co., Ltd., Shenzhen, Guangdong 518129 (CN)
(72) Inventor: LI, Yue, Shenzhen, Guangdong 518129 (CN); CHEN, Wang, Shenzhen, Guangdong 518129 (CN); ZHANG, Heng, Shenzhen, Guangdong 518129 (CN); WANG, Zhenlei, Shenzhen, Guangdong 518129 (CN); XU, Jianhua, Shenzhen, Guangdong 518129 (CN); JIN, Guodong, Shenzhen, Guangdong 518129 (CN); SONG, Xinghua, Shenzhen, Guangdong 518129 (CN); SONG, Woeiji, Shenzhen, Guangdong 518129 (CN); XU, Jeffrey Junhao, Shenzhen, Guangdong 518129 (CN)
(74) Representative: Thun, Clemens
(86) International application number: PCT/CN2024/127857
(87) International publication number: WO 2025/139317

(57) **Abstract**

This application relates to the field of semiconductor technologies, and provides a ferroelectric capacitor and a preparation method therefor, a memory array, a memory, and an electronic device, to reduce M phases in a ferroelectric layer of the ferroelectric capacitor and improve reliability of the ferroelectric capacitor. The ferroelectric capacitor includes a first electrode (10), a second electrode (20), and the ferroelectric layer (30), where the ferroelectric layer (30) is located between the first electrode (10) and the second electrode (20); the first electrode (10) is a polycrystalline material, the first electrode (10) includes a first columnar grain, a first included angle exists between an extension direction of the first columnar grain and a first reference surface, and the first included angle is greater than 0 degrees and less than or equal to 90 degrees; a percentage of a quantity of the first columnar grains in a quantity of all grains in the first electrode (10) is greater than or equal to 50%; and the first reference surface is parallel to a part that is of a surface of the ferroelectric layer (30) and that is opposite to the first columnar grain. The ferroelectric capacitor is used in an electronic device, to improve performance of the electronic device.

## Description

This application claims priority to Chinese Patent Application No. 202311872523.0, filed with the China National Intellectual Property Administration on December 29, 2023 and entitled "FERROELECTRIC CAPACITOR AND PREPARATION METHOD THEREFOR, MEMORY ARRAY, MEMORY, AND ELECTRONIC DEVICE", which is incorporated herein by reference in its entirety.

### TECHNICAL FIELD

This application relates to the field of semiconductor technologies, and in particular, to a ferroelectric capacitor and a preparation method therefor, a memory array, a memory, and an electronic device.

### BACKGROUND

Currently, a ferroelectric random access memory (Ferroelectric Random Access Memory, FeRAM for short in English) has been widely used for its features such as non-volatile data storage and a high access rate.

Generally, the ferroelectric random access memory includes a plurality of ferroelectric capacitors, and a ferroelectric capacitor includes two electrodes disposed opposite to each other and a ferroelectric layer located between the two electrodes. Under clamping effect of the two electrodes, the ferroelectric layer undergoes a high-temperature crystallization process to form a polycrystalline thin film with a mixture of orthorhombic phases (Orthorhombic, O phases), tetragonal phases (Tetragonal, T phases), and monoclinic phases (monoclinic, M phases). The O phases and the T phases enable the ferroelectric layer to have a ferroelectric property, while the M phases impart a dielectric characteristic to the ferroelectric layer. Oxygen ions in the O phases can deviate from an equilibrium point under the drive of a voltage, and generate two polarization states in opposite directions, which are used for storing 0/1 information. There are more M phases in the ferroelectric layer, and therefore the ferroelectric layer is prone to problems such as fatigue (fatigue) and breakdown. This severely affects reliability of the ferroelectric random access memory.

### SUMMARY

Embodiments of this application provide a ferroelectric capacitor and a preparation method therefor, a memory array, a memory, and an electronic device, to reduce M phases in a ferroelectric layer of the ferroelectric capacitor and improve reliability of the ferroelectric capacitor.

To achieve the foregoing objectives, the following technical solutions are used in embodiments of this application.

According to a first aspect, a ferroelectric capacitor is provided. The ferroelectric capacitor includes a first electrode, a second electrode, and a ferroelectric layer, where the ferroelectric layer is located between the first electrode and the second electrode; the first electrode is a polycrystalline material, the first electrode includes a first columnar grain, a first included angle exists between an extension direction of the first columnar grain and a first reference surface, and the first included angle is greater than 0 degrees and less than or equal to 90 degrees; a percentage of a quantity of the first columnar grains in a quantity of all grains in the first electrode is greater than or equal to 50%; and the first reference surface is parallel to a part that is of a surface of the ferroelectric layer and that is opposite to the first columnar grain.

In such disposition, the first electrode can have an almost no preferred orientation of a (200) crystal orientation, and fewer M phases and more O phases are generated in the ferroelectric layer. There are fewer M phases and more O phases in the ferroelectric layer. A coercive electric field of the ferroelectric capacitor can be reduced, and an operating voltage of the ferroelectric capacitor can be reduced, so that an operating voltage and power consumption can be low when a memory cell using the ferroelectric capacitor provided in embodiments of this application performs a read/write operation. In addition, a fatigue period of the ferroelectric capacitor can be delayed, and a leakage current of the ferroelectric capacitor can be reduced. This increases a quantity of storage times of the ferroelectric capacitor, ensures a memory window of the ferroelectric capacitor after a plurality of storage times, improves reliability of the ferroelectric capacitor, further ensures accuracy of the read/write operation of the memory cell using the ferroelectric capacitor provided in embodiments of this application, and improves performance of a memory.

Further, there are fewer M phases and more O phases in the ferroelectric layer, to enable a film layer of the ferroelectric layer to have a good bearing capability, and enable the ferroelectric capacitor to have a more stable structure. This can ensure a storage capability of the ferroelectric capacitor, improve reliability of the ferroelectric capacitor, reduce a loss rate of the memory window of a memory array (memory) using the ferroelectric capacitor, ensure accuracy of the read/write operation of the memory array, and reduce a false read rate.

In some embodiments, the ferroelectric capacitor further includes a third electrode, where the third electrode is located on a side that is of the first electrode and that is away from the ferroelectric layer, and the third electrode is an amorphous material or a polycrystalline material with a randomly distributed crystal orientation.

In this way, the first electrode and the third electrode are located on a same side of the ferroelectric layer, the first electrode and the third electrode can jointly provide clamping stress for the ferroelectric layer, and a thickness of the first electrode can be small. During the preparation of the ferroelectric capacitor, to enable the first electrode to be the polycrystalline material, the first electrode to include the first columnar grain, the first included angle to exist between the extension direction of the first columnar grain and the first reference surface, and the percentage of the quantity of the first columnar grains in the quantity of all the grains in the first electrode to be greater than or equal to 50%, a process condition needs to be adjusted when the first electrode is prepared, for example, a temperature, a reaction gas flow rate, and a reaction device power need to be adjusted. The thickness of the first electrode is small, to enable preparation duration of the first electrode to be short. This helps reduce preparation difficulty and process complexity of the ferroelectric capacitor, and improve preparation efficiency of the ferroelectric capacitor.

In some embodiments, the ferroelectric capacitor further includes a first buffer layer, where the first buffer layer is located between the first electrode and the ferroelectric layer, and is in contact with the ferroelectric layer.

In such disposition, the first buffer layer is disposed between the first electrode and the ferroelectric layer. This can further adjust stress between the first electrode and the ferroelectric layer, and improve structural stability of the ferroelectric capacitor. In addition, the first buffer layer can be further disposed to suppress diffusion of metal particles in the first electrode into the ferroelectric layer, suppress diffusion of oxygen atoms in the ferroelectric layer into the first electrode, reduce oxygen vacancies formed in the ferroelectric layer due to movement of the oxygen ions, weaken oxidation effect between the electrode and the oxygen ions, avoid formation of a conductive path in the ferroelectric layer, reduce a leakage current of the ferroelectric capacitor, avoid breakdown of the ferroelectric capacitor, and prolong a service life of the ferroelectric capacitor. Further, the oxygen vacancies in the ferroelectric layer are reduced. This can further improve polarization fatigue and an imprint effect caused by the oxygen vacancies, and improve accuracy of reading/writing data by the memory cell using the ferroelectric capacitor.

In some embodiments, the second electrode is a polycrystalline material, the second electrode includes a second columnar grain, a second included angle exists between an extension direction of the second columnar grain and a second reference surface, and the second included angle is greater than 0 degrees and less than or equal to 90 degrees; a percentage of a quantity of the second columnar grains in a quantity of all grains in the second electrode is greater than or equal to 50%; and the second reference surface is parallel to a part that is of the surface of the ferroelectric layer and that is opposite to the second columnar grain. In this way, the second electrode can also have an almost no preferred orientation of a (200) crystal orientation, and fewer M phases and more O phases are generated in the ferroelectric layer.

In some embodiments, the ferroelectric capacitor further includes a fourth electrode, where the fourth electrode is located on a side that is of the second electrode and that is away from the ferroelectric layer, and the fourth electrode is an amorphous material or a polycrystalline material with a randomly distributed crystal orientation.

In this way, the second electrode and the fourth electrode are located on a same side of the ferroelectric layer, the second electrode and the fourth electrode can jointly provide clamping stress for the ferroelectric layer, and a thickness of the second electrode can be small. During the preparation of the ferroelectric capacitor, to enable the second electrode to include the second columnar grain, the second included angle to exist between the extension direction of the second columnar grain and the second reference surface, and the percentage of the quantity of the second columnar grains in the quantity of all the grains in the second electrode to be greater than or equal to 50%, a process condition needs to be adjusted when the second electrode is prepared, for example, a temperature, a reaction gas flow rate, and a reaction device power need to be adjusted. The thickness of the second electrode is small, to enable preparation duration of the second electrode to be short. This helps reduce preparation difficulty and process complexity of the ferroelectric capacitor, and improve preparation efficiency of the ferroelectric capacitor.

In some embodiments, the ferroelectric capacitor further includes a second buffer layer, where the second buffer layer is located between the second electrode and the ferroelectric layer, and is in contact with the ferroelectric layer. Similar to a function principle of the first buffer layer in the foregoing embodiment, the second buffer layer can be disposed to prolong the service life of the ferroelectric capacitor, improve accuracy of reading/writing the data of the memory cell using the ferroelectric capacitor, and improve structural stability of the ferroelectric capacitor.

In some embodiments, a material of the ferroelectric layer includes a hafnium oxide-based material and a doping element, and the doping element includes at least one of zirconium, lanthanum, aluminum, titanium, and niobium.

In some embodiments, a material of the first electrode includes at least one of metal, conductive oxide, and conductive nitride; and/or a material of the second electrode includes at least one of metal, conductive oxide, and conductive nitride.

In some embodiments, both the first electrode and the second electrode are planar electrodes, and the first electrode and the second electrode are stacked. In this way, the ferroelectric capacitor can have a simple structure. This helps simplify a preparation process of the ferroelectric capacitor and reduce preparation costs.

In some embodiments, a surface that is of the first electrode and that is close to the ferroelectric layer includes a connection surface, a first side surface, and a second side surface, the first side surface and the second side surface are located on two opposite sides of the connection surface and are both connected to the connection surface, and extension directions of the first side surface and the second side surface are different from an extension direction of the connection surface; the ferroelectric layer is disposed opposite to the connection surface, the first side surface, and the second side surface; and the second electrode is located on a side that is of the ferroelectric layer and that is away from the first electrode, and is disposed opposite to the connection surface, the first side surface, and the second side surface.

In this way, an area in which the first electrode and the second electrode of the ferroelectric capacitor face each other can be large, to enable a capacitance value of the ferroelectric capacitor to be large. When the ferroelectric capacitor provided in embodiments of this application is used in the memory, the capacitance value of the ferroelectric capacitor can still meet a requirement of the memory even if an occupied area of the ferroelectric capacitor is small. This helps reduce a size of the memory and implement miniaturization and high integration.

According to a second aspect, a preparation method for a ferroelectric capacitor is provided. The preparation method includes: forming a first electrode; forming a ferroelectric layer; and forming a second electrode, where the ferroelectric layer is located between the first electrode and the second electrode; the first electrode includes a first columnar grain, a first included angle exists between an extension direction of the first columnar grain and a first reference surface, and the first included angle is greater than 0 degrees and less than or equal to 90 degrees; a percentage of a quantity of the first columnar grains in a quantity of all grains in the first electrode is greater than or equal to 50%; and the first reference surface is parallel to a part that is of a surface of the ferroelectric layer and that is opposite to the first columnar grain.

According to a third aspect, a memory array is provided. The memory array includes a plurality of memory cells, the plurality of memory cells include a transistor and the ferroelectric capacitor according to any one of the foregoing embodiments, and the transistor is connected to the ferroelectric capacitor.

According to a fourth aspect, a memory is provided. The memory includes a controller and the memory array according to any one of the foregoing embodiments, and the controller is electrically connected to the memory array.

According to a fifth aspect, an electronic device is provided. The electronic device includes a circuit board and the memory according to any one of the foregoing embodiments, and the memory is located on the circuit board and is electrically connected to the circuit board.

For technical effect brought by any design in the second aspect to the fifth aspect, refer to technical effect brought by the different designs in the first aspect. Details are not described herein again.

### BRIEF DESCRIPTION OF DRAWINGS

To describe technical solutions in this application more clearly, the following briefly describes accompanying drawings used for some embodiments of this application. It is clear that the accompanying drawings in the following descriptions are merely accompanying drawings in some embodiments of this application. A person of ordinary skill in the art may further derive other accompanying drawings from these accompanying drawings. In addition, the accompanying drawings in the following descriptions may be considered as diagrams, and are not intended to limit an actual size of a product, an actual procedure of a method, an actual timing of a signal, and the like in embodiments of this application.
FIG. 1 is a diagram of a structure of an electronic device according to some embodiments;
FIG. 2 is a diagram of a structure of a memory according to some embodiments;
FIG. 3 is a diagram of a structure of another memory according to some embodiments;
FIG. 4 is a diagram of a structure of a memory array according to some embodiments;
FIG. 5 is a diagram of a structure of another memory array according to some embodiments;
FIG. 6 is a diagram of a structure of a ferroelectric capacitor according to some embodiments;
FIG. 7 is a diagram of a structure of another ferroelectric capacitor according to some embodiments;
FIG. 8 is a diagram of XRD test results of a first electrode and a reference electrode;
FIG. 9A and FIG. 9B are diagrams of TEM test results of a first electrode and a reference electrode;
FIG. 10 is a diagram of a structure of another ferroelectric capacitor according to some embodiments;
FIG. 11 is a diagram of a structure of another ferroelectric capacitor according to some embodiments;
FIG. 12 is a diagram of a structure of another ferroelectric capacitor according to some embodiments;
FIG. 13 is a diagram of a structure of another ferroelectric capacitor according to some embodiments;
FIG. 14 is a diagram of a structure of another ferroelectric capacitor according to some embodiments;
FIG. 15 is a diagram of a structure of another ferroelectric capacitor according to some embodiments;
FIG. 16 is a diagram of a structure of another ferroelectric capacitor according to some embodiments;
FIG. 17 is a diagram of a structure of another ferroelectric capacitor according to some embodiments;
FIG. 18 is a diagram of a structure of another ferroelectric capacitor according to some embodiments;
FIG. 19 is a diagram of a structure of another ferroelectric capacitor according to some embodiments;
FIG. 20A is a diagram of a structure of another ferroelectric capacitor according to some embodiments;
FIG. 20B is a diagram of a structure of another ferroelectric capacitor according to some embodiments;
FIG. 21 is a diagram of a structure of another ferroelectric capacitor according to some embodiments; and
FIG. 22 is a flowchart of a preparation method for a ferroelectric capacitor according to some embodiments.

### DESCRIPTION OF EMBODIMENTS

The following clearly and completely describes technical solutions in some embodiments of this application with reference to accompanying drawings. It is clear that the described embodiments are merely some rather than all embodiments of this application. All other embodiments obtained by a person of ordinary skill in the art based on embodiments of this application shall fall within the protection scope of this application.

In descriptions of this application, it should be understood that orientations or position relationships indicated by terms such as "center", "above", "below", "front", "rear", "left", "right", "vertical", "horizontal", "top", "bottom", "inside", and "outside" are based on the orientations or the position relationships shown in the accompanying drawings, and are merely intended to describe this application and simplify the descriptions, but not intended to indicate or imply that an indicated apparatus or element shall have a specific direction or be constructed and operated in a specific orientation. Therefore, such terms cannot be understood as a limitation on this application.

Unless otherwise required in the context, throughout the entire specification and claims, the term "include" is interpreted as "being open and inclusive", that is, "include but not limited to". In descriptions of this specification, terms such as "an embodiment", "some embodiments", "an example embodiment", "an example", or "some examples" are intended to indicate that a specific feature, structure, material, or characteristic related to embodiments or examples are included in at least one embodiment or example of this application. The foregoing schematic representations of the terms do not necessarily refer to a same embodiment or example. Further, the particular feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of the number of indicated technical features. Therefore, a feature limited by "first" or "second" may explicitly or implicitly include one or more features. In descriptions of embodiments of this application, unless otherwise specified, "a plurality of" means two or more.

"A and/or B" includes the following three combinations: only A, only B, and a combination of A and B.

In addition, use of "based on" means openness and inclusiveness, because a process, a step, calculation, or another action "based on" one or more conditions or values may be based in practice on additional conditions or values beyond the described values.

In the content of this application, the meanings of "on", "above", and "on the top of" should be interpreted in a broadest manner, so that "on" means not only "directly on something", but also includes the meaning of "on something" with an intermediate feature or layer between associated objects, and "above" or "on the top of" not only means "above" or "on the top of" something, but also includes the meaning of being "above" or "on the top of" something (that is, directly on something) without an intermediate feature or layer between the associated objects.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending feature. Therefore, the regions shown in the accompanying drawings are essentially examples, and their shapes are not intended to show actual shapes of regions of a device, and are not intended to limit a scope of the example implementations.

Embodiments of this application provide an electronic device. The electronic device is, for example, a consumer electronic product, a home electronic product, a vehicle-mounted electronic product, a financial terminal product, or a communication electronic product. The consumer electronic product is, for example, a mobile phone (mobile phone), a tablet computer (pad), a notebook computer, an e-reader, a game console, a camera, a personal computer (personal computer, PC), a personal digital assistant (personal digital assistant, PDA), a desktop display, a smart wearable (for example, a smart watch or a smart band), a virtual reality (virtual reality, VR) terminal device, an augmented reality (augmented reality, AR) terminal device, or an uncrewed aerial vehicle. The home electronic product is, for example, a smart door lock, a television, a remote control, a refrigerator, a small household charging appliance (for example, a soy milk maker or a robot vacuum), or a set-top box. The vehicle-mounted electronic product is, for example, a vehicle-mounted navigator, a vehicle-mounted high-density digital video disc (digital video disc, DVD), an automatic assisted driving system for vehicles, a navigation and infotainment system, a powertrain, or a battery management system. The financial terminal product is, for example, an automated teller machine (automated teller machine, ATM), a POS (Point of sales) function machine terminal for self-service business handling, or the like. A specific form of the electronic device is not specifically limited in embodiments of this application.

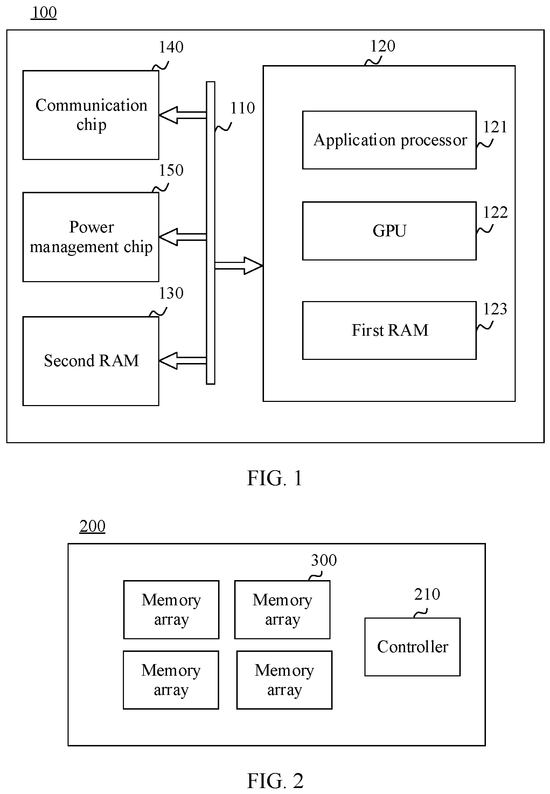

FIG. 1 is a diagram of a structure of an electronic device 100 according to an embodiment of this application. As shown in FIG. 1, the electronic device 100 may include a bus 110 and a system on chip (system on chip, SoC) 120 connected to the bus 110. The SoC 120 may be configured to process data, for example, process data of an application, process image data, and cache temporary data. In an implementation, the SoC 120 may include an application processor (application processor, AP) 121 configured to process an application, a graphics processing unit (graphics processing unit, GPU) 122 configured to process image data, and a first random access memory (random access memory, RAM) 123 configured to cache high-speed data. The first RAM 123 may be a static random access memory (static random access memory, SRAM), or the like. The AP 121, the GPU 122, and the first RAM 123 may be integrated into one die (die), or may be disposed in a plurality of dies.

Still as shown in FIG. 1, the electronic device 100 may further include a second RAM 130 connected to the SoC 120 via the bus 110. The second RAM 130 may be a dynamic random access memory (dynamic random access memory, DRAM). The second RAM 130 may be configured to store volatile data, for example, temporary data generated by the SoC 120. A storage capacity of the second RAM 130 is usually greater than that of the first RAM 123, but a reading speed of the second RAM 130 is usually slower than that of the first RAM 123.

In addition, the electronic device 100 may further include a communication chip 140 and a power management chip 150 that are connected to the SoC 120 via the bus 110. The communication chip 140 may be configured to process a protocol stack, or perform processing such as amplification and filtering on an analog radio frequency signal, or implement the foregoing functions at the same time. The power management chip 150 may be configured to supply power to another chip. In an implementation, the SoC 120 and the second RAM 130 may be packaged in a packaging structure, for example, 2.5D (dimension) or 3D packaging is used, to obtain a faster inter-chip data transmission rate.

FIG. 2 is a block diagram of a circuit of a memory 200 used in an electronic device according to an embodiment of this application. In an implementation, the memory 200 may be the first RAM 123 or the second RAM 130 shown in FIG. 1. An application scenario of the memory 200 in this application is not limited. In a possible implementation, the memory 200 may alternatively be a RAM disposed outside the SoC 120. A location of the memory 200 in the electronic device and a location relationship between the memory 200 and the SoC 120 are not limited in this application.

As shown in FIG. 2, the memory 200 includes a memory array 300. In addition, the memory 200 may further include a controller 210 configured to access the memory array 300, where the controller 210 is configured to control a read/write operation of the memory array 300.

It may be understood that the memory 200 may include at least one memory array 300, that is, the memory 200 may include one or more memory arrays.

The memory array 300 and the controller 210 have a plurality of packaging structures that can be implemented. For example, the memory array 300 and the controller 210 are two chips independent of each other, and the memory array 300 and the controller 210 are separately integrated on a substrate. For example, the memory array 300 and the controller 210 may be electrically connected through a metal wire routed on the substrate. In this structure, because the memory array 300 and the controller 210 are two independent chips, the memory array 300 may be referred to as a stand-alone (stand-alone) memory.

Alternatively, the memory array 300 and the controller 210 are stacked. For example, the memory array 300 and the controller 210 may be connected via a through silicon via (through silicon via, TSV) or a redistribution layer (redistribution layer, RDL).

Alternatively, the memory array 300 and the controller 210 are integrated into a same chip, and the chip is integrated on a substrate. Therefore, the memory array 300 may be referred to as an embedded memory.

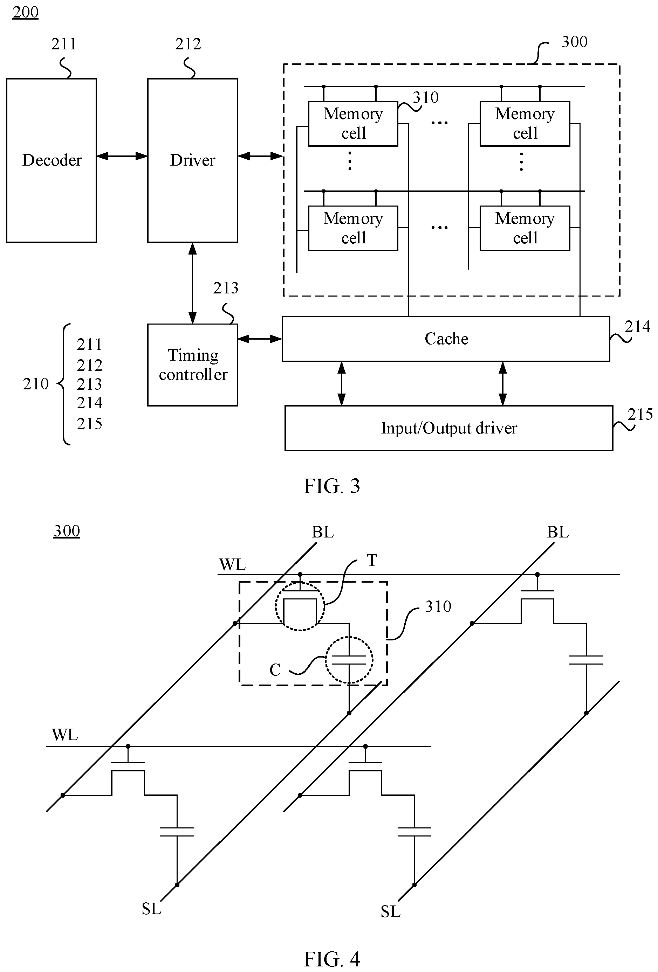

In some examples, as shown in FIG. 3, the memory array 300 may include a plurality of memory cells 310, and each memory cell 310 may be configured to store 1-bit (bit) or multi-bit data. The memory array 300 may further include signal lines such as a word line (word line, WL) and a bit line (bit line, BL). Each memory cell 310 is electrically connected to a corresponding word line and a corresponding bit line. Different memory cells 310 may be electrically connected through word lines and bit lines. One or more of the word lines and the bit lines are configured to select, by receiving a control level output by a control circuit, a to-be-read/written memory cell 310 in the memory array, to implement a data read/write operation.

The controller 210 in the memory may include one or more circuit structures of a decoder 211, a driver 212, a timing controller 213, a cache 214, or an input/output driver 215 shown in FIG. 3.

In a structure of the memory 200 shown in FIG. 3, the decoder 211 is configured to perform decoding based on a received address, to determine a to-be-accessed memory cell 310. The driver 212 is configured to control a level of a signal line based on a decoding result generated by the decoder 211, to access the specified memory cell 310. The cache 214 is configured to cache read data, for example, may cache the data in a first-in first-out (first-in first-out, FIFO) manner. The timing controller 213 is configured to: control timing of the cache 214, and control the driver 212 to drive the signal line in the memory array 300. The input/output driver 215 is configured to drive a transmission signal, for example, drive a received data signal and drive a data signal that needs to be sent, so that the data signals can be transmitted over a long distance.

The memory array 300, the decoder 211, the driver 212, the timing controller 213, the cache 214, and the input/output driver 215 may be integrated into one chip, or may be respectively integrated into a plurality of chips.

The memory in this application may be a ferroelectric random access memory (ferroelectric random access memory, FeRAM), or may be a ferroelectric field-effect transistor (ferroelectric field-effect transistor, FeFET) memory or a ferroelectric tunnel junction (ferroelectric tunnel junction, FTJ) memory, or may be a resistive random access memory (Resistive Random Access Memory, RRAM).

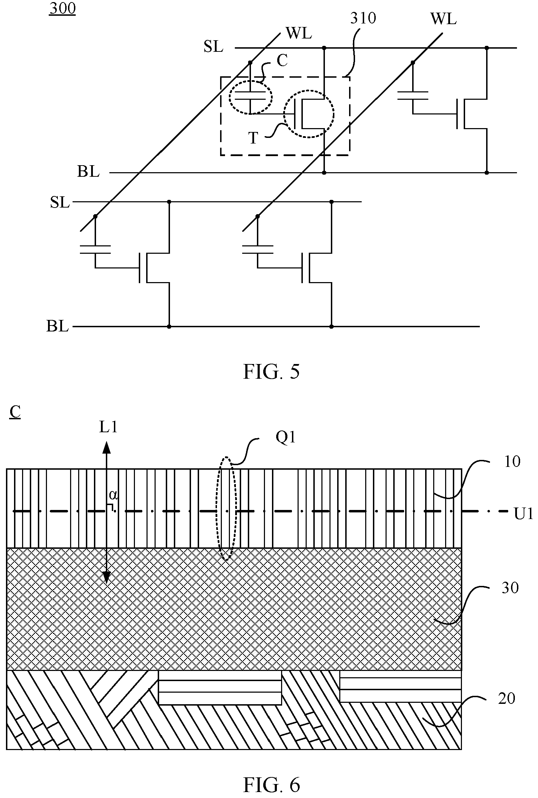

FIG. 4 and FIG. 5 are diagrams of circuit structures of two possible memory arrays 300 according to embodiments of this application. As shown in FIG. 4 and FIG. 5, the memory array 300 may include a plurality of memory cells 310, and a memory cell 310 includes one transistor T and one ferroelectric capacitor C. The memory array may further include word lines WLs, bit lines BLs, and source lines SLs. FIG. 4 shows four memory cells 310 in the memory array 300. In the memory cell 310, a first end of the ferroelectric capacitor C is connected to a first electrode of the transistor T, a second end of the ferroelectric capacitor C is connected to a source line SL, a second electrode of the transistor T is connected to a bit line BL, and a control end (for example, a gate electrode) of the transistor T is connected to a word line WL.

FIG. 5 also shows four memory cells 310 in the memory array 300. Different from that in the memory cell 310 shown in FIG. 4, in the memory cell 310, a first end of the ferroelectric capacitor C is connected to a control end (for example, a gate electrode) of the transistor T, a second end of the ferroelectric capacitor C is connected to a word line WL, a first electrode of the transistor T is connected to a source line SL, and a second electrode of the transistor T is connected to a bit line BL.

It may be understood that the quantity of memory cells 310 shown in FIG. 4 and FIG. 5 does not limit a quantity of memory cells 310 in the memory array 300 provided in embodiments of this application. The quantity of memory cells 310 in the memory array 300 provided in embodiments of this application may be designed based on an actual requirement. A structure of the memory cell 310 in embodiments of this application is not limited to structures shown in FIG. 4 and FIG. 5. A single memory cell 310 may also include a plurality of transistors T and a plurality of ferroelectric capacitors C.

Generally, a ferroelectric capacitor includes two electrodes disposed opposite to each other and a ferroelectric layer located between the two electrodes. Under clamping effect of the two electrodes, the ferroelectric layer undergoes a high-temperature crystallization process to form a polycrystalline thin film with a mixture of orthorhombic phases (Orthorhombic, O phases), tetragonal phases (Tetragonal, T phases), and monoclinic phases (monoclinic, M phases). The O phases and the T phases enable the ferroelectric layer to have a ferroelectric property, while the M phases impart a dielectric characteristic to the ferroelectric layer.

Crystals in ferroelectric phases (namely, the orthorhombic phases and the tetragonal phases) are formed in the ferroelectric layer, and when an electric field is applied to the ferroelectric layer, central atoms of the crystals stop in a low-energy state following the electric field. When a reversed electric field is applied to the ferroelectric layer, the central atoms move in the crystals in the direction of the electric field and stop in another low-energy state. A large quantity of central atoms move and are coupled in a crystal cell to form ferroelectric domains (ferroelectric domains). The ferroelectric domains form a polarization charge under an action of the electric field, and polarization charges formed by the ferroelectric domains before and after electric field reversal are different in energy. In this binary stable state, the ferroelectric capacitor is charged and discharged, which can be identified by the external circuit to implement a "0" or "1" storage state.

An electrode of the ferroelectric capacitor is crucial for the ferroelectric property of the ferroelectric layer. An electrode of an existing ferroelectric capacitor is generally made of conductive materials such as titanium nitride (TiN), tungsten (W), and ruthenium (Ru), resulting in the electrode having a microstructure that is in an amorphous state or in a polycrystalline state with a randomly distributed crystal orientation. The electrode in the amorphous state or in the polycrystalline state with the randomly distributed crystal orientation cannot effectively induce the ferroelectric layer. Consequently, the M phase is more likely to occur in the ferroelectric layer, causing problems such as fatigue and breakdown of the ferroelectric layer. This severely affects performance and competitiveness of the memory.

Based on this, as shown in FIG. 6, an embodiment of this application provides a ferroelectric capacitor C. The ferroelectric capacitor C includes a first electrode 10, a second electrode 20, and a ferroelectric layer 30 located between the first electrode 10 and the second electrode 20. The first electrode 10 is a polycrystalline material, the first electrode 10 includes a first columnar grain Q1, a first included angle α exists between an extension direction L1 of the first columnar grain Q1 and a first reference surface U1, and the first included angle α is greater than 0 degrees and less than or equal to 90 degrees; a percentage of a quantity of the first columnar grains Q1 in a quantity of all grains in the first electrode 10 is greater than or equal to 50%; and the first reference surface U1 is parallel to a part that is of a surface of the ferroelectric layer 30 and that is opposite to the first columnar grain Q1.

In FIG. 6, an example in which the extension direction L1 of the first columnar grain Q1 is perpendicular to the first reference surface U1, that is, the included angle α between the extension direction L1 of the first columnar grain Q1 and the first reference surface U1 is 90 degrees, is used for illustration. Certainly, the first included angle α between the extension direction L1 of the first columnar grain Q1 and the first reference surface U1 may alternatively be 30 degrees, 45 degrees, 60 degrees, 70 degrees, 75 degrees, 80 degrees, or the like.

It may be understood that the polycrystalline material includes a plurality of first columnar grains Q1, and included angles between extension directions L1 of different first columnar grains Q1 and the first reference surface U1 may be different. That is, in a plurality of first columnar grains Q1 in the polycrystalline material, extension directions L1 of different first columnar grains Q1 may be different. For example, some of the plurality of first columnar grains Q1 have different extension directions L1, and the other first columnar grains Q1 have same extension directions L1. For another example, an extension direction L1 of at least one first columnar grain Q1 in the plurality of first columnar grains Q1 is different from extension directions L1 of a plurality of first columnar grains Q1 around the first columnar grain Q1.

A height, a cross-sectional shape, and a cross-sectional size of the first columnar grain Q1 are not limited in embodiments of this application. In the plurality of first columnar grains Q1 in the polycrystalline material, heights of different first columnar grains Q1 may be the same or may be different. Cross-sectional shapes of different first columnar grains Q1 may be the same or may be different. Cross-sectional sizes of different first columnar grains Q1 may be the same or may be different.

In FIG. 6, an example in which the percentage of the quantity of the first columnar grains Q1 in the quantity of all the grains in the first electrode 10 is 100% is used for illustration. In some other possible examples, the percentage of the quantity of the first columnar grains Q1 in the quantity of all the grains in the first electrode 10 may be 50%, 60%, 70%, 80%, 90%, or the like.

In some examples, a material of the first electrode 10 and a material of the second electrode 20 may include at least one of metal, conductive oxide, and conductive nitride. The metal may be, for example, W (tungsten), Pt (platinum), Sr (strontium), Ru (ruthenium), La (lanthanum), Mn (manganese), Ti (titanium), Au (gold), Ag (silver), or Al (aluminum). The conductive oxide may be, for example, TiO (titanium oxide), NbO (niobium oxide), RuO₂ (ruthenium oxide), IrO (iridium oxide), ITO (indium tin oxide), AZO (aluminum-doped zinc oxide), or FTO (fluorine-doped tin oxide). The conductive nitride may be, for example, TiN (titanium nitride), TiAlN (titanium aluminum nitride), WN (tungsten nitride), or TaN (tantalum nitride).

When the foregoing "metal, conductive oxide, and conductive nitride" are prepared by using different processes, structures of the "metal, conductive oxide, and conductive nitride" may be different. In other words, the foregoing "metal, conductive oxide, and conductive nitride" may be amorphous materials, or may be polycrystalline materials with randomly distributed crystal orientations, or may have columnar grains.

It may be understood that when the material of the first electrode 10 includes the at least one of metal, conductive oxide, and conductive nitride, the "metal, conductive oxide, and conductive nitride" are all polycrystalline materials, and include the first columnar grain Q1. The first included angle α exists between the extension direction L1 of the first columnar grain Q1 and the first reference surface U1, and the percentage of the quantity of the first columnar grains Q1 in the quantity of all the grains in the first electrode 10 is greater than or equal to 50%.

For example, a thickness of the first electrode 10 may be 10 nm to 300 nm. For example, the thickness of the first electrode 10 is 10 nm, 20 nm, 30 nm, 50 nm, 60 nm, 80 nm, 100 nm, 200 nm, 300 nm, or the like. In this way, the thickness of the first electrode 10 is not excessively small, and structural stability of the first electrode 10 can be high. This can ensure clamping effect of the first electrode 10 on the ferroelectric layer 30, and can ensure generation of a ferroelectric phase in the ferroelectric layer 30. In addition, the thickness of the first electrode 10 is not excessively large, so that preparation costs of the first electrode 10 are not excessively high, and preparation time is not excessively long. This helps control costs and preparation efficiency of the ferroelectric capacitor C.

For example, a thickness of the second electrode 20 may be 10 nm to 300 nm. For example, the thickness of the second electrode 20 is 10 nm, 20 nm, 30 nm, 50 nm, 60 nm, 80 nm, 100 nm, 200 nm, 300 nm, or the like. In this way, the thickness of the second electrode 20 is not excessively small, and structural stability of the second electrode 20 can be high. This can ensure clamping effect of the second electrode 20 on the ferroelectric layer 30, and can ensure generation of a ferroelectric phase in the ferroelectric layer 30. In addition, the thickness of the second electrode 20 is not excessively large, so that preparation costs of the second electrode 20 are not excessively high, and preparation time is not excessively long. This helps control costs and preparation efficiency of the ferroelectric capacitor C.

It may be understood that the thickness of the first electrode 10 and the thickness of the second electrode 20 in embodiments of this application are not limited to the foregoing examples.

In some examples, a material of the ferroelectric layer 30 may include a hafnium oxide-based material and a doping element. The hafnium oxide-based material may include hafnium oxide or hafnium zirconium oxide, and the doping element may include at least one of zirconium (Zr), lanthanum (La), aluminum (Al), titanium (Ti), and niobium (Nb). It may be understood that when the doping element is zirconium, the material of the ferroelectric layer 30 may further include zirconium oxide; when the doping element is lanthanum, the material of the ferroelectric layer 30 may further include lanthanum oxide; when the doping element is aluminum, the material of the ferroelectric layer 30 may further include aluminum oxide; when the doping element is Ti, the material of the ferroelectric layer 30 may further include titanium oxide; and when the doping element is niobium, the material of the ferroelectric layer 30 may further include niobium oxide. Certainly, to provide the doping element for the ferroelectric layer 30, the ferroelectric layer 30 may further include another material including lanthanum, aluminum, titanium, and niobium.

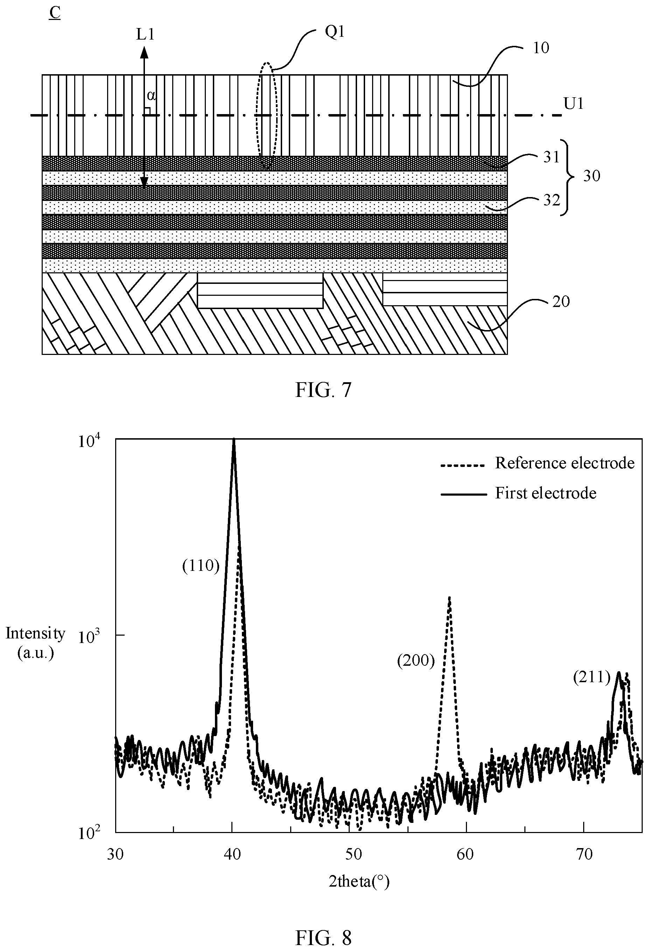

In some examples, as shown in FIG. 6, the ferroelectric layer 30 may be of a single-layer structure. In some other examples, as shown in FIG. 7, the ferroelectric layer 30 may be of a multi-layer structure.

For example, the material of the ferroelectric layer 30 includes hafnium oxide, and the doping element is zirconium. When the ferroelectric layer 30 is of the single-layer structure, the ferroelectric layer 30 may be of an alloy structure in which hafnium oxide and a single molecular layer of zirconium oxide are interleaved. When the ferroelectric layer 30 is of the multi-layer structure, the ferroelectric layer 30 may include a plurality of alternately stacked hafnium oxide layers 31 and zirconium oxide layers 32. Alternatively, when the ferroelectric layer 30 is of the multi-layer structure, the ferroelectric layer 30 may include a plurality of alternately stacked hafnium-zirconium oxide layers (having a ferroelectric property) that are rich in hafnium elements and hafnium-zirconium oxide layers (having an anti-ferroelectric property) that are rich in zirconium elements. Herein, "rich in the hafnium elements" means that content of the hafnium elements in the hafnium-zirconium oxide layer is higher than content of zirconium elements, and "rich in the zirconium elements" means that content of the zirconium elements in the hafnium-zirconium oxide layer is higher than content of hafnium elements.

When the ferroelectric layer 30 includes the plurality of alternately stacked hafnium oxide layers 31 and zirconium oxide layers 32, a film layer that is closest to the first electrode 10 and that is in the ferroelectric layer 30 may be a hafnium oxide layer 31, and a film layer that is closest to the second electrode 20 and that is in the ferroelectric layer 30 may be a zirconium oxide layer 32; or a film layer that is closest to the first electrode 10 and that is in the ferroelectric layer 30 may be a zirconium oxide layer 32, and a film layer that is closest to the first electrode 10 and that is in the ferroelectric layer 30 may be a hafnium oxide layer 31. Certainly, when the ferroelectric layer 30 includes the plurality of alternately stacked hafnium oxide layers 31 and zirconium oxide layers 32, both a film layer that is closest to the first electrode 10 and that is in the ferroelectric layer 30 and a film layer that is closest to the second electrode 20 and that is in the ferroelectric layer 30 may be hafnium oxide layers 31 or zirconium oxide layers 32.

It may be understood that because strength of a chemical bond between hafnium and oxygen is different from strength of a chemical bond between zirconium and oxygen, the hafnium oxide layer 31 and the zirconium oxide layer 32 have different binding effect on oxygen ions, and the hafnium oxide layer and the zirconium oxide layer have different oxygen ion concentrations. In addition, a lattice matching degree between the hafnium oxide layer 31 and the first electrode 10 is different from a lattice matching degree between the zirconium oxide layer 32 and the first electrode 10. Therefore, stress between the hafnium oxide layer 31 and the first electrode 10 is different from stress between the zirconium oxide layer 32 and the first electrode 10. Certainly, a lattice matching degree between the hafnium oxide layer 31 and the second electrode 20 is also different from a lattice matching degree between the zirconium oxide layer 32 and the second electrode 20. Therefore, stress between the hafnium oxide layer 31 and the second electrode 20 is also different from stress between the zirconium oxide layer 32 and the second electrode 20.

A magnitude of stress applied by the first electrode 10 to the ferroelectric layer 30, a magnitude of stress applied by the second electrode 20 to the ferroelectric layer 30, and an oxygen ion concentration in the ferroelectric layer 30 all affect generation of the M phase and O phase in the ferroelectric layer, and therefore affect a property of the ferroelectric capacitor C. Therefore, when the ferroelectric layer 30 includes the plurality of alternately stacked hafnium oxide layers 31 and zirconium oxide layers 32, a quantity of film layers and a sequence of the film layers in the hafnium oxide layers 31 and the zirconium oxide layers 32 in the ferroelectric layer 30 can be adjusted, to improve performance of the ferroelectric capacitor C.

For example, when both the film layer closest to the first electrode 10 and the film layer closest to the second electrode 20 in the ferroelectric layer 30 are the hafnium oxide layers 31, a memory window of the ferroelectric capacitor C may be large. When both the film layer closest to the first electrode 10 and the film layer closest to the second electrode 20 in the ferroelectric layer 30 are the zirconium oxide layers 32, the ferroelectric capacitor C is not prone to reliability problems such as fatigue or breakdown.

Certainly, performance of the ferroelectric capacitor C in a case in which the ferroelectric layer 30 is of the single-layer structure is also different from performance of the ferroelectric capacitor C in a case in which the ferroelectric layer 30 is of the multi-layer structure. For example, when the ferroelectric layer 30 is of the alloy structure in which hafnium oxide and a single molecular layer of zirconium oxide are interleaved, storage time of the ferroelectric capacitor using the ferroelectric layer 30 may be long. When the ferroelectric layer 30 is of the multi-layer structure, a memory window of the ferroelectric capacitor using the ferroelectric layer 30 may be large, a quantity of read/write operations may be large, and reliability of the ferroelectric capacitor C may be high.

A thickness of the ferroelectric layer 30 is not limited in embodiments of this application, and may be designed based on an actual requirement. When the ferroelectric layer 30 is of the multi-layer structure, a thickness of each sublayer (for example, the foregoing hafnium oxide layer and zirconium oxide layer) in the ferroelectric layer 30 may also be designed based on an actual requirement. For example, when the ferroelectric layer 30 includes the plurality of alternately stacked hafnium oxide layers and zirconium oxide layers, thicknesses of the hafnium oxide layers and zirconium oxide layers may be at a nanometer level.

The first electrode 10 and a reference electrode (a polycrystalline electrode with a random crystal orientation) are separately detected by using an X-ray diffraction (X-ray Diffraction, XRD) technology, to obtain a diagram of test results shown in FIG. 8. Both the material of the first electrode 10 and a material of the reference electrode are tungsten (W).

In the diagram of the test results shown in FIG. 8, a horizontal coordinate is 2theta, namely, a diffraction angle, in a unit of degree (°). The diffraction angle is an included angle between an incident X-ray and a diffracted ray, theta is referred to as a diffraction half-angle, and the diffraction half-angle is an included angle between an incident X-ray and a crystal surface that meets a diffraction condition. A vertical coordinate is intensity, namely, intensity after X-ray diffraction. A unit of the vertical coordinate is a.u. (arbitrary unit, arbitrary unit). In FIG. 8, a "solid line" represents a diffraction curve of the first electrode 10, and a "dashed line" represents a diffraction curve of the reference electrode.

As shown in FIG. 8, there are three high wave peaks in the detected curve of the reference electrode, and the three wave peaks from left to right respectively represent that a (110) crystal orientation, a (200) crystal orientation, and a (211) crystal orientation exist in the reference electrode. However, there are only two high wave peaks in the detected curve of the first electrode, and the two wave peaks from left to right respectively represent that a (110) crystal orientation and a (211) crystal orientation exist in the first electrode, and a (200) crystal orientation basically does not exist in the first electrode.

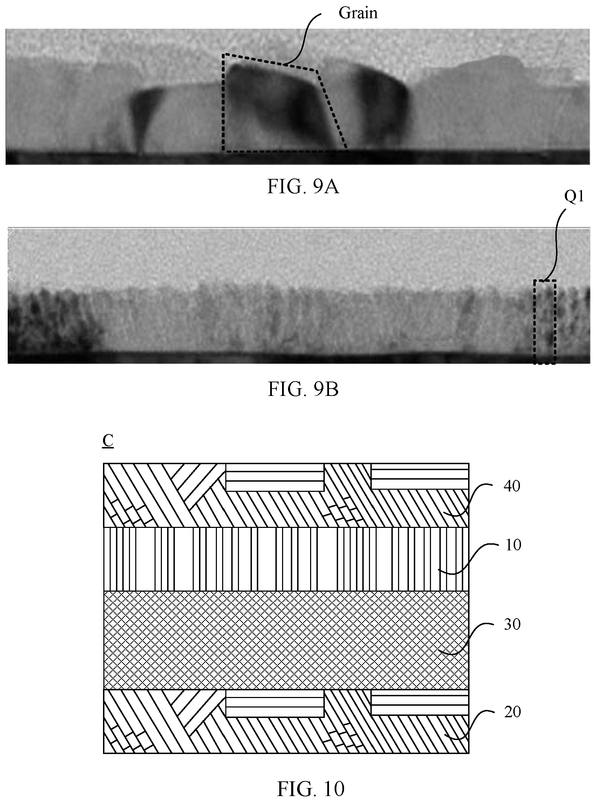

Diagrams of results shown in FIG. 9A and FIG. 9B may be obtained by observing the first electrode and the reference electrode via a transmission electron microscope, where an observation result of the reference electrode is in FIG. 9A, and a diagram of an observation result of the first electrode is FIG. 9B. Refer to FIG. 9A. Because grain crystallization orientations in the reference electrode are randomly distributed, grains in the reference electrode easily combine with each other to form a large overall structure. In addition, growth speeds of a single grain in the reference electrode in different directions are balanced, to enable sizes of the single grain in the different directions to be large, and a volume of the single grain to be large. However, the first electrode 10 provided in embodiments of this application has an almost no preferred orientation of the (200) crystal orientation, and growth speeds of the first columnar grain in the first electrode 10 in different directions are uneven. Therefore, the first columnar grain Q1 in the first electrode may be columnar and extend along a thickness direction of the first electrode 10.

It is found through research that the (200) crystal orientation in the electrode of the ferroelectric capacitor easily induces generation of the M phase in the ferroelectric layer, and the (110) crystal orientation in the electrode easily induces generation of the O phase in the ferroelectric layer. Therefore, when the (200) crystal orientation basically does not exist in the first electrode, there are fewer M phases and more O phases in the ferroelectric layer of the ferroelectric capacitor provided in embodiments of this application.

Based on this, in the ferroelectric capacitor C provided in embodiments of this application, the first electrode 10 is the polycrystalline material, the first electrode 10 includes the first columnar grain Q1, the first included angle α exists between the extension direction L1 of the first columnar grain Q1 and the first reference surface U1, and the first included angle α is greater than 0 degrees and less than or equal to 90 degrees; and the percentage of the quantity of the first columnar grains Q1 in the quantity of all the grains in the first electrode 10 is greater than or equal to 50%, so that fewer M phases and more O phases are generated in the ferroelectric layer 30.

There are fewer M phases and more O phases in the ferroelectric layer 30. A coercive electric field of the ferroelectric capacitor C can be reduced, and an operating voltage of the ferroelectric capacitor C can be reduced, so that an operating voltage and power consumption can be low when a memory cell using the ferroelectric capacitor C provided in embodiments of this application performs a read/write operation. In addition, a fatigue period of the ferroelectric capacitor C can be delayed, and a leakage current of the ferroelectric capacitor C can be reduced. This increases a quantity of storage times of the ferroelectric capacitor C, ensures a memory window of the ferroelectric capacitor C after a plurality of storage times, improves reliability of the ferroelectric capacitor, further ensures accuracy of the read/write operation of the memory cell 310 using the ferroelectric capacitor C provided in embodiments of this application, and improves performance of a memory.

Further, there are fewer M phases and more O phases in the ferroelectric layer 30, to enable a film layer of the ferroelectric layer 30 to have a good bearing capability, and enable the ferroelectric capacitor C to have a more stable structure. This can ensure a storage capability of the ferroelectric capacitor C, improve reliability of the ferroelectric capacitor, reduce a loss rate of the memory window of a memory array (memory) using the ferroelectric capacitor C, ensure accuracy of the read/write operation of the memory array, and reduce a false read rate.

In some examples, the first included angle α between the extension direction L1 of the first columnar grain Q1 and the first reference surface U1 may be greater than or equal to 30 degrees and less than or equal to 90 degrees. In this way, it is more difficult to generate the (200) crystal orientation in the first electrode 10. This can further reduce the M phases in the ferroelectric layer 30, and enable the ferroelectric layer 30 to have more O phases.

In some embodiments, as shown in FIG. 10, the ferroelectric capacitor C may further include a third electrode 40, and the third electrode 40 is located on a side that is of the first electrode 10 and that is away from the ferroelectric layer 30. The third electrode 40 is an amorphous material or a polycrystalline material with a randomly distributed crystal orientation.

In this way, the first electrode 10 and the third electrode 40 are located on a same side of the ferroelectric layer 30, the first electrode 10 and the third electrode 40 can jointly provide clamping stress for the ferroelectric layer 30, and the thickness of the first electrode 10 can be small. During the preparation of the ferroelectric capacitor C, to enable the first electrode 10 to be the polycrystalline material, the first electrode 10 to include the first columnar grain Q1, the first included angle α to exist between the extension direction L1 of the first columnar grain Q1 and the first reference surface U1, and the percentage of the quantity of the first columnar grains Q1 in the quantity of all the grains in the first electrode 10 to be greater than or equal to 50%, a process condition needs to be adjusted when the first electrode 10 is prepared, for example, a temperature, a reaction gas flow rate, and a reaction device power need to be adjusted. The thickness of the first electrode 10 is small, to enable preparation duration of the first electrode 10 to be short. This helps reduce preparation difficulty and process complexity of the ferroelectric capacitor, and improve preparation efficiency of the ferroelectric capacitor.

In some embodiments, refer to FIG. 10. When the first electrode 10 is the polycrystalline material, the first electrode 10 includes the first columnar grain Q1, and the first included angle α exists between the extension direction L1 of the first columnar grain Q1 and the first reference surface U1, the second electrode 20 may be an amorphous material or a polycrystalline material with a randomly distributed crystal orientation.

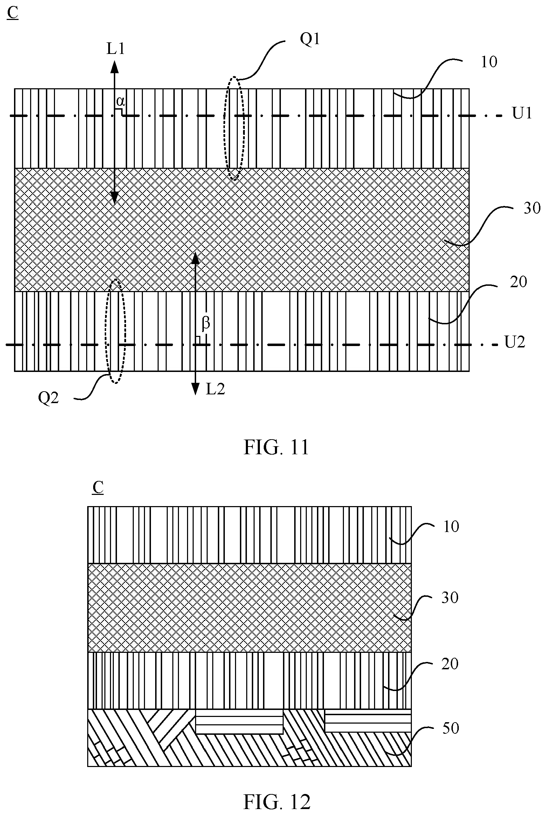

In some other embodiments, as shown in FIG. 11, when the first electrode 10 is the polycrystalline material, the first electrode 10 includes the first columnar grain Q1, and the first included angle α exists between the extension direction L1 of the first columnar grain Q1 and the first reference surface U1, the second electrode 20 may be a polycrystalline material, the second electrode 20 includes a second columnar grain Q2, a second included angle β exists between an extension direction of the second columnar grain Q2 and a second reference surface U2, and the second included angle β is greater than 0 degrees and less than or equal to 90 degrees. A percentage of a quantity of the second columnar grains β in a quantity of all grains in the second electrode 20 is greater than or equal to 50%. The second reference surface U2 is parallel to a part that is of the surface of the ferroelectric layer 30 and that is opposite to the second columnar grain Q2.

In FIG. 11, an example in which the extension direction L2 of the second columnar grain Q2 is perpendicular to the second reference surface U2, that is, the second included angle β between the extension direction L2 of the second columnar grain Q2 and the second reference surface U2 is 90 degrees, is used for illustration. Certainly, the second included angle β between the extension direction L2 of the second columnar grain Q2 and the second reference surface U2 may alternatively be 30 degrees, 45 degrees, 60 degrees, 70 degrees, 75 degrees, 80 degrees, or the like.

It may be understood that the second electrode 20 includes a plurality of second columnar grains Q2, and second included angles between extension directions L2 of different second columnar grains Q2 and the second reference surface U2 may be different. That is, in a plurality of second columnar grains Q2 in the polycrystalline material, extension directions L2 of different second columnar grains Q2 may be different. For example, some of the plurality of second columnar grains Q2 have different extension directions L2, and the other second columnar grains Q2 have same extension directions L2. For another example, an extension direction L2 of at least one second columnar grain Q2 in the plurality of second columnar grains Q2 is different from extension directions L2 of a plurality of second columnar grains Q2 around the second columnar grain Q2.

In FIG. 11, an example in which the percentage of the quantity of the second columnar grains Q2 in the quantity of all the grains in the second electrode 20 is 100% is used for illustration. In some other possible examples, the percentage of the quantity of the second columnar grains Q2 in the quantity of all the grains in the second electrode 20 may be 50%, 60%, 70%, 80%, 90%, or the like.

In the ferroelectric capacitor C provided in embodiments of this application, the second electrode 20 is the polycrystalline material, the second electrode 20 includes the second columnar grain Q2, the second included angle β exists between the extension direction of the second columnar grain Q2 and the second reference surface U2, and the second included angle β is greater than 0 degrees and less than or equal to 90 degrees; and the percentage of the quantity of the second columnar grains β in the quantity of all the grains in the second electrode 20 is greater than or equal to 50%. The second electrode 20 also has an almost no preferred orientation of the (200) crystal orientation, so that fewer M phases and more O phases are generated in the ferroelectric layer 30.

In some examples, the second included angle β between the extension direction L2 of the second columnar grain Q2 and the second reference surface U2 may be greater than or equal to 30 degrees and less than or equal to 90 degrees. In this way, it is more difficult to generate the (200) crystal orientation in the second electrode 20. This can further reduce the M phases in the ferroelectric layer 30, and enable the ferroelectric layer 30 to have more O phases.

In some embodiments, as shown in FIG. 12, when the second electrode 20 is the polycrystalline material, the second electrode 20 includes the second columnar grain Q2, and the second included angle β exists between the extension direction L2 of the second columnar grain Q2 and the second reference surface U2, the ferroelectric capacitor C may further include a fourth electrode 50, and the fourth electrode 50 is located on a side that is of the second electrode 20 and that is away from the ferroelectric layer 30. The fourth electrode 50 is an amorphous material or a polycrystalline material with a randomly distributed crystal orientation.

In this way, the second electrode 20 and the fourth electrode 50 are located on a same side of the ferroelectric layer 30, the second electrode 20 and the fourth electrode 50 can jointly provide clamping stress for the ferroelectric layer 30, and the thickness of the second electrode 20 can be small. In the process in which the ferroelectric capacitor C is prepared, to enable the second electrode 20 to include the second columnar grain Q2, and the second included angle β to exist between the extension direction of the second columnar grain Q2 and the second reference surface U2, the percentage of the quantity of the second columnar grains B in the quantity of all the grains in the second electrode 20 is greater than or equal to 50%. When the second electrode 20 is prepared, a process condition needs to be adjusted, for example, a temperature, a reaction gas flow rate, and a reaction device power are adjusted. The thickness of the second electrode 20 is small, to enable preparation duration of the second electrode 20 to be short. This helps reduce preparation difficulty and process complexity of the ferroelectric capacitor C, and improve preparation efficiency of the ferroelectric capacitor C.

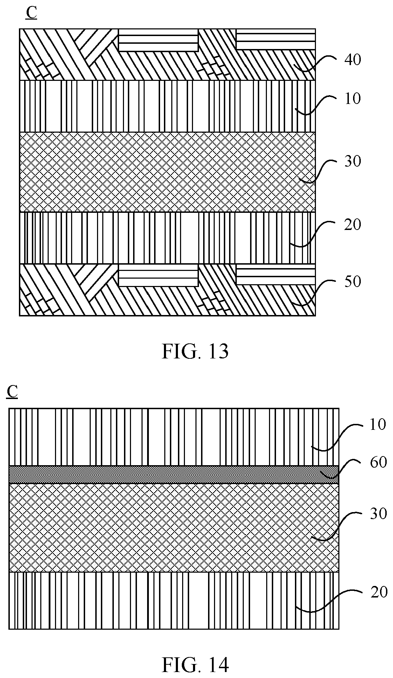

In some embodiments, as shown in FIG. 13, when the first electrode 10 is the polycrystalline material, the first electrode 10 includes the first columnar grain Q1, and the first included angle α exists between the extension direction L1 of the first columnar grain Q1 and the first reference surface U1; and the second electrode 20 is the polycrystalline material, the second electrode 20 includes the second columnar grain Q2, and the second included angle β exists between the extension direction L2 of the second columnar grain Q2 and the second reference surface U2, the ferroelectric capacitor C may include both the third electrode 40 and the fourth electrode 50.

In this way, the first electrode 10 and the third electrode 40 are located on the same side of the ferroelectric layer 30, and the first electrode 10 and the third electrode 40 can jointly provide the clamping stress for the ferroelectric layer 30. The second electrode 20 and the fourth electrode 50 are located on the same side of the ferroelectric layer 30, and the second electrode 20 and the fourth electrode 50 can jointly provide the clamping stress for the ferroelectric layer 30. Thicknesses of both the first electrode 10 and the second electrode 20 can be small. This helps shorten preparation time of the first electrode 10 and the second electrode 20 in the process in which the ferroelectric capacitor C is prepared, and improve preparation efficiency of the ferroelectric capacitor C.

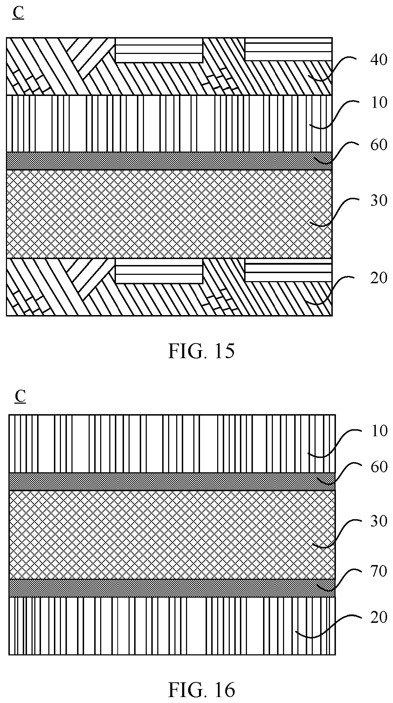

FIG. 14 and FIG. 15 are diagrams of structures of two ferroelectric capacitors C according to embodiments of this application. In some embodiments, as shown in FIG. 14 and FIG. 15, the ferroelectric capacitor C may further include a first buffer layer 60, where the first buffer layer 60 is located between the first electrode 10 and the ferroelectric layer 30, and is in contact with the ferroelectric layer 30. Compared with the ferroelectric capacitor C shown in FIG. 14, the ferroelectric capacitor C shown in FIG. 15 is further provided with the third electrode 40.

For example, a material of the first buffer layer 60 may include a material like titanium oxide, niobium oxide, cerium oxide, or silicon nitride. A thickness of the first buffer layer 60 is not limited in embodiments of this application, and may be designed based on an actual requirement.

In embodiments of this application, the first buffer layer 60 is disposed between the first electrode 10 and the ferroelectric layer 30, and the first buffer layer 60 can adjust stress between the first electrode 10 and the ferroelectric layer 30. This improves structural stability of the ferroelectric capacitor C. In addition, the first buffer layer can further suppress diffusion of metal particles in the first electrode 10 into the ferroelectric layer 30, suppress diffusion of oxygen atoms in the ferroelectric layer 30 into the first electrode 10, reduce oxygen vacancies formed in the ferroelectric layer due to movement of the oxygen ions, weaken oxidation effect between the electrode and the oxygen ions, avoid formation of a conductive path in the ferroelectric layer, reduce a leakage current of the ferroelectric capacitor, avoid breakdown of the ferroelectric capacitor, and prolong a service life of the ferroelectric capacitor. Further, the oxygen vacancies in the ferroelectric layer 30 are reduced. This can further improve polarization fatigue and an imprint effect caused by the oxygen vacancies, and improve accuracy of reading/writing data by the memory cell 310 using the ferroelectric capacitor C.

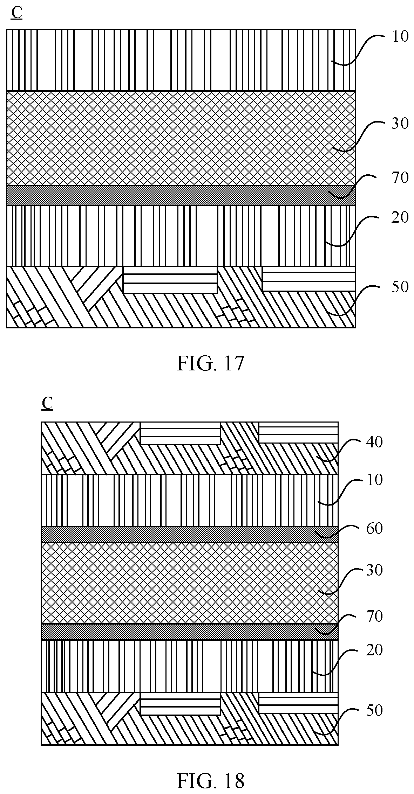

FIG. 16 and FIG. 17 are diagrams of structures of two ferroelectric capacitors C according to embodiments of this application. In some embodiments, as shown in FIG. 16 and FIG. 17, the ferroelectric capacitor C may further include a second buffer layer 70, where the second buffer layer 70 is located between the second electrode 20 and the ferroelectric layer 30, and is in contact with the ferroelectric layer 30. Compared with the ferroelectric capacitor C shown in FIG. 16, the ferroelectric capacitor C shown in FIG. 17 is further provided with the fourth electrode 50. When the ferroelectric capacitor C includes the second buffer layer 70, the ferroelectric capacitor C may include the first buffer layer 60 (as shown in FIG. 16), or may not include the first buffer layer 60 (as shown in FIG. 17).

For example, a material of the second buffer layer 70 may include a material like titanium oxide, niobium oxide, cerium oxide, or silicon nitride. A thickness of the second buffer layer 70 is not limited in embodiments of this application, and may be designed based on an actual requirement.

The material of the second buffer layer 70 may be the same as or different from the material of the first buffer layer 60. A thickness of the second buffer layer 70 may be the same as or different from a thickness of the first buffer layer 60.

In embodiments of this application, the second buffer layer 70 is disposed between the second electrode 20 and the ferroelectric layer 30, and can suppress diffusion of metal particles in the second electrode 20 into the ferroelectric layer 30, suppress diffusion of oxygen atoms in the ferroelectric layer 30 into the second electrode 20, reduce oxygen vacancies formed in the ferroelectric layer due to movement of the oxygen ions, weaken oxidation effect between the electrode and the oxygen ions, avoid formation of a conductive path in the ferroelectric layer, reduce a leakage current of the ferroelectric capacitor, avoid breakdown of the ferroelectric capacitor, and prolong a service life of the ferroelectric capacitor. Further, the oxygen vacancies in the ferroelectric layer 30 are reduced. This can further improve polarization fatigue and an imprint effect caused by the oxygen vacancies, and improve accuracy of reading/writing data by the memory cell 310 using the ferroelectric capacitor C. In addition, the second buffer layer 70 is disposed between the second electrode 20 and the ferroelectric layer 30, and can adjust stress between the second electrode 20 and the ferroelectric layer 30. This improves structural stability of the ferroelectric capacitor C.

FIG. 18 is a diagram of a structure of the ferroelectric capacitor C according to this embodiment of this application. In some other embodiments, as shown in FIG. 18, in addition to the first electrode 10, the second electrode 20, and the ferroelectric layer 30, the ferroelectric capacitor C may further include the third electrode 40, the fourth electrode 50, the first buffer layer 60, and the second buffer layer 70. For functions of the third electrode 40, the fourth electrode 50, the first buffer layer 60, and the second buffer layer 70, refer to the foregoing example. Details are not described herein again.

In some embodiments, the ferroelectric capacitor C may be of a two-dimensional structure. In this case, as shown in FIG. 18, both the first electrode 10 and the second electrode 20 may be planar electrodes, and the first electrode 10 and the second electrode 20 are stacked. In this way, the ferroelectric capacitor C can have a simple structure. This helps simplify a preparation process of the ferroelectric capacitor C and reduce preparation costs.

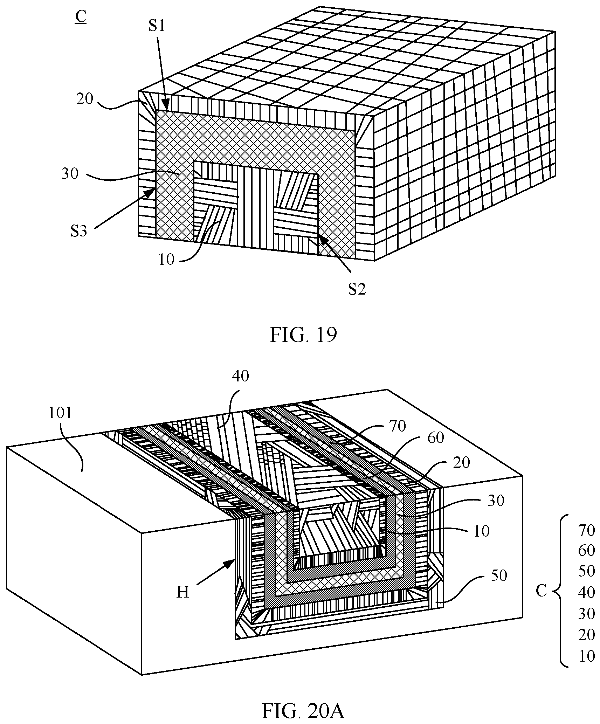

In some other embodiments, the ferroelectric capacitor C may be of a three-dimensional structure. In this case, as shown in FIG. 19, a surface that is of the first electrode 10 and that is close to the ferroelectric layer 30 includes a connection surface S1, a first side surface S2, and a second side surface S3. The first side surface S2 and the second side surface S3 are located on two opposite sides of the connection surface S1, and are both connected to the connection surface S1, and extension directions of the first side surface S2 and the second side surface S3 are different from an extension direction of the connection surface S1. The ferroelectric layer 30 is disposed opposite to the connection surface S1, the first side surface S2, and the second side surface S3. The second electrode 20 is located on a side that is of the ferroelectric layer 30 and that is away from the first electrode 10, and is disposed opposite to the connection surface S1, the first side surface S2, and the second side surface S3.

In this way, an area in which the first electrode 10 and the second electrode 20 of the ferroelectric capacitor C face each other can be large, to enable a capacitance value of the ferroelectric capacitor C to be large. When the ferroelectric capacitor C provided in embodiments of this application is used in the memory, the capacitance value of the ferroelectric capacitor C can still meet a requirement of the memory even if an occupied area of the ferroelectric capacitor C is small. This helps reduce a size of the memory and implement miniaturization and high integration.

In some examples, as shown in FIG. 20A, the ferroelectric capacitor C may be located on a substrate 101, the substrate 101 has a groove H, and the ferroelectric capacitor C is located in the groove H and serves as a trench capacitor.

In some possible examples, the second electrode of the ferroelectric capacitor C covers a bottom wall and a side wall of the groove. The ferroelectric layer is located on an inner side of the second electrode. The first electrode is located on an inner side of the ferroelectric layer and fills the groove.

FIG. 20A is illustrated by using an example in which the ferroelectric capacitor C includes the first electrode 10, the second electrode 20, the ferroelectric layer 30, the third electrode 40, the fourth electrode 50, the first buffer layer 60, and the second buffer layer 70. In some other possible examples, as shown in FIG. 20A, the fourth electrode 50 is located in the groove H of the substrate 101, and covers a bottom wall and an inner wall of the groove H. The second electrode 20 is located on an inner side of the fourth electrode 50. The second buffer layer 70 is located on an inner side of the second electrode 20. The ferroelectric layer 30 is disposed on an inner side of the second buffer layer 70. The first buffer layer 60 is disposed on an inner side of the ferroelectric layer 30. The first electrode 10 is disposed on an inner side of the first buffer layer 60. The third electrode 40 is disposed on an inner side of the first electrode 10 and fills the groove H. Certainly, when the ferroelectric capacitor C is the trench capacitor, a structure of the ferroelectric capacitor C is not limited thereto.

In some other examples, the ferroelectric capacitor C may be located on the substrate 101, and the ferroelectric capacitor C may be a fin capacitor. In this case, refer to FIG. 19. The first electrode 10 may be a cuboid, and the first electrode 10 includes the connection surface S1, the first side surface S2, and the second side surface S3. The first side surface S2 and the second side surface S3 are respectively located on the two sides of the connection surface, and are both connected to the connection surface. The extension directions of the first side surface S1 and the second side surface S2 are different from the extension direction of the connection surface S1. The ferroelectric layer 30 covers the first electrode 10, and is disposed opposite to the connection surface S1, the first side surface S2, and the second side surface S3. The second electrode 20 is located on the side that is of the ferroelectric layer 30 and that is away from the first electrode 10, and is disposed opposite to the connection surface S1, the first side surface S2, and the second side surface S3.

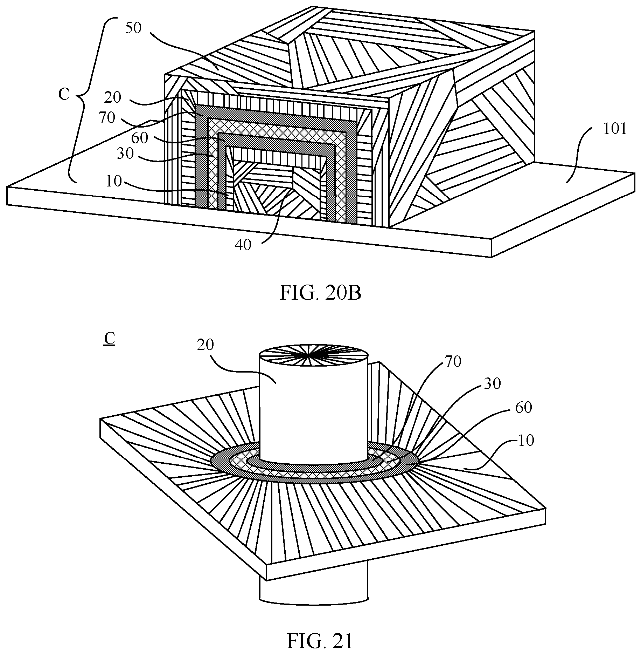

FIG. 20B is illustrated by using an example in which the ferroelectric capacitor C includes the first electrode 10, the second electrode 20, the ferroelectric layer 30, the third electrode 40, the fourth electrode 50, the first buffer layer 60, and the second buffer layer 70. In some other possible examples, refer to FIG. 20B. The fourth electrode 50 may be fin-shaped. The second electrode 20 covers a surface of the fourth electrode 50. The second buffer layer 70, the ferroelectric layer 30, the first buffer layer 60, the first electrode 10, and the third electrode 40 sequentially cover a surface of the second electrode 20.

In some other examples, as shown in FIG. 21, the first electrode 10 of the ferroelectric capacitor C may be a planar electrode, the second electrode 20 may be a columnar electrode, the second electrode 20 penetrates the first electrode 10 (that is, the first electrode 10 is disposed around the second electrode 20), and the ferroelectric layer 30 is located between the first electrode 10 and the second electrode 20.

Refer to FIG. 21. In addition to the first electrode 10, the second electrode 20, and the ferroelectric layer 30, the ferroelectric capacitor C may further include the first buffer layer 60 and the second buffer layer 70. The first buffer layer 60 is located between the first electrode 10 and the ferroelectric layer 30, and the second buffer layer 70 is located between the second electrode 20 and the ferroelectric layer 30.

In some other examples, when the ferroelectric capacitor C includes the first electrode 10, the second electrode 20, the ferroelectric layer 30, the third electrode 40, the fourth electrode 50, the first buffer layer 60, and the second buffer layer 70, the third electrode 40 may be a planar electrode, the fourth electrode 50 may be a columnar electrode, the fourth electrode 50 penetrates the third electrode 40, and between the fourth electrode 50 and the third electrode 40, the second electrode 20, the second buffer layer 70, the ferroelectric layer 30, the first buffer layer 60, and the first electrode 10 are sequentially arranged along a direction in which the fourth electrode 50 points to the third electrode 40.

The foregoing embodiments of this application show three possible structures in a case in which the ferroelectric capacitor C is of the three-dimensional structure. However, it may be understood that the structure of the ferroelectric capacitor C is not limited thereto.

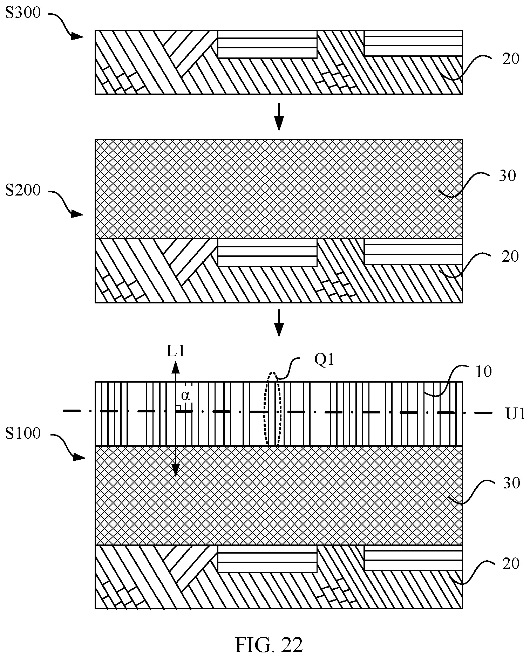

As shown in FIG. 22, an embodiment of this application provides a preparation method for a ferroelectric capacitor. The preparation method includes step S100, step S200, and step S300. S100: Form a first electrode 10. S200: Form a ferroelectric layer 30. S300: Form a first electrode 20.

The ferroelectric layer 30 is located between the first electrode 10 and the second electrode 20. The first electrode 10 is a polycrystalline material, the first electrode 10 includes a first columnar grain Q1, a first included angle α exists between an extension direction L1 of the first columnar grain Q1 and the first reference surface U1, and the first included angle α is greater than 0 degrees and less than or equal to 90 degrees. A percentage of a quantity of the first columnar grains Q1 in a quantity of all grains in the first electrode 10 is greater than or equal to 50%. The first reference surface U1 is parallel to a part that is of a surface of the ferroelectric layer 30 and that is opposite to the first columnar grain Q1.

In the foregoing preparation method, for optional materials of the first electrode 10, the second electrode 20, and the ferroelectric layer 30, refer to the foregoing descriptions of the structure of the ferroelectric capacitor C in this application. Details are not described herein again.

When the first electrode 10, the second electrode 20, or the ferroelectric layer 30 is prepared, a magnetron sputtering deposition method may be used, or a thin film deposition method may be used, for example, a deposition process like chemical vapor deposition (chemical vapor deposition, CVD), physical vapor deposition (physical vapor deposition, PVD), or atomic layer deposition (atomic layer deposition, ALD). In this way, the prepared first electrode 10, second electrode 20, or ferroelectric layer 30 can be uniform, and have high flatness and high conformality, that is, layer structures have basically consistent shapes and surface flatness.

When the ferroelectric capacitor C is of a three-dimensional structure, during the preparation of the first electrode 10, the second electrode 20, or the ferroelectric layer 30, a photolithography process, an etching process (for example, a dry etching process or a wet etching process), a chemical mechanical polishing (Chemical Mechanical Polishing, CMP) process, or the like may also be used.

For example, a manner of controlling a process condition may be used, so that the first electrode 10 is the polycrystalline material, the first electrode 10 includes the first columnar grain Q1, the first included angle α exists between the extension direction L1 of the first columnar grain Q1 and the first reference surface U1, the first included angle α is greater than 0 degrees and less than or equal to 90 degrees, and the percentage of the quantity of the first columnar grains Q1 in the quantity of all the grains in the first electrode 10 to be greater than or equal to 50%. For example, the process condition like a temperature, a reaction gas flow rate, and a reaction device power may be adjusted, so that the first electrode 10 includes the first columnar grain Q1, the first included angle α exists between the extension direction L1 of the first columnar grain Q1 and the first reference surface U1, the first included angle α is greater than 0 degrees and less than or equal to 90 degrees, and the percentage of the quantity of the first columnar grains Q1 in the quantity of all the grains in the first electrode 10 to be greater than or equal to 50%. It may be understood that when preparation materials of the selected first electrode 10 are different, adjustment trends (increase or decrease) of the process conditions may also be different.

A sequence of step S100, step S200, and step S300 is not limited in embodiments of this application, and may be designed based on an actual situation. FIG. 22 is a flowchart of a possible preparation method for the ferroelectric capacitor. As shown in FIG. 22, the second electrode 20 may be first formed (step S300), and then the ferroelectric layer 30 is formed (step S200). The ferroelectric layer 30 is located on one side of the second electrode 20. Finally, the first electrode 10 is formed (step S100), and the first electrode 10 is located on a side that is of the ferroelectric layer 30 and that is away from the second electrode 20. That is, the ferroelectric capacitor is prepared in a sequence of step S300, step S200, and step S100.

In the descriptions of this specification, the described specific features, structures, materials, or characteristics may be combined in a proper manner in any one or more of embodiments or examples. The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A ferroelectric capacitor, comprising:
a first electrode and a second electrode, and
a ferroelectric layer, located between the first electrode and the second electrode, wherein
the first electrode is a polycrystalline material, the first electrode comprises a first columnar grain, a first included angle exists between an extension direction of the first columnar grain and a first reference surface, and the first included angle is greater than 0 degrees and less than or equal to 90 degrees; a percentage of a quantity of the first columnar grains in a quantity of all grains in the first electrode is greater than or equal to 50%; and the first reference surface is parallel to a part that is of a surface of the ferroelectric layer and that is opposite to the first columnar grain.

2. The ferroelectric capacitor according to claim 1, further comprising:
a third electrode, located on a side that is of the first electrode and that is away from the ferroelectric layer, wherein the third electrode is an amorphous material or a polycrystalline material with a randomly distributed crystal orientation.

3. The ferroelectric capacitor according to claim 1 or 2, further comprising:
a first buffer layer, located between the first electrode and the ferroelectric layer, and in contact with the ferroelectric layer.

4. The ferroelectric capacitor according to any one of claims 1 to 3, wherein the second electrode is a polycrystalline material, the second electrode comprises a second columnar grain, a second included angle exists between an extension direction of the second columnar grain and a second reference surface, and the second included angle is greater than 0 degrees and less than or equal to 90 degrees; a percentage of a quantity of the second columnar grains in a quantity of all grains in the second electrode is greater than or equal to 50%; and the second reference surface is parallel to a part that is of the surface of the ferroelectric layer and that is opposite to the second columnar grain.

5. The ferroelectric capacitor according to claim 4, further comprising:
a fourth electrode, located on a side that is of the second electrode and that is away from the ferroelectric layer, wherein the fourth electrode is an amorphous material or a polycrystalline material with a randomly distributed crystal orientation.

6. The ferroelectric capacitor according to any one of claims 1 to 5, further comprising:
a second buffer layer, located between the second electrode and the ferroelectric layer, and in contact with the ferroelectric layer.

7. The ferroelectric capacitor according to any one of claims 1 to 6, wherein
a material of the ferroelectric layer comprises a hafnium oxide-based material and a doping element, and the doping element comprises at least one of zirconium, lanthanum, aluminum, titanium, and niobium.

8. The ferroelectric capacitor according to any one of claims 1 to 7, wherein a material of the first electrode comprises at least one of metal, conductive oxide, and conductive nitride; and/or
a material of the second electrode comprises at least one of metal, conductive oxide, and conductive nitride.

9. The ferroelectric capacitor according to any one of claims 1 to 8, wherein both the first electrode and the second electrode are planar electrodes, and the first electrode and the second electrode are stacked.

10. The ferroelectric capacitor according to any one of claims 1 to 8, wherein a surface that is of the first electrode and that is close to the ferroelectric layer comprises a connection surface, a first side surface, and a second side surface, the first side surface and the second side surface are located on two opposite sides of the connection surface and are both connected to the connection surface, and extension directions of the first side surface and the second side surface are different from an extension direction of the connection surface; the ferroelectric layer is disposed opposite to the connection surface, the first side surface, and the second side surface; and the second electrode is located on a side that is of the ferroelectric layer and that is away from the first electrode, and is disposed opposite to the connection surface, the first side surface, and the second side surface.

11. A preparation method for a ferroelectric capacitor, comprising:
forming a first electrode;
forming a ferroelectric layer; and
forming a second electrode, wherein
the ferroelectric layer is located between the first electrode and the second electrode; the first electrode is a polycrystalline material, the first electrode comprises a first columnar grain, a first included angle exists between an extension direction of the first columnar grain and a first reference surface, and the first included angle is greater than 0 degrees and less than or equal to 90 degrees; a percentage of a quantity of the first columnar grains in a quantity of all grains in the first electrode is greater than or equal to 50%; and the first reference surface is parallel to a part that is of a surface of the ferroelectric layer and that is opposite to the first columnar grain.

12. A memory array, comprising:
a plurality of memory cells, comprising a transistor and the ferroelectric capacitor according to any one of claims 1 to 10, wherein the transistor is connected to the ferroelectric capacitor.

13. A memory, comprising:
the memory array according to claim 12; and
a controller, electrically connected to the memory array.

14. An electronic device, comprising:
the memory according to claim 13; and
a circuit board, wherein the memory is located on the circuit board and is electrically connected to the circuit board.
